# EUROPEAN PATENT SPECIFICATION

(11) **EP 3 172 948 B1**
(45) Date of publication and mention of the grant of the patent: **15.11.2017**
(21) Application number: 15742014.2
(22) Date of filing: 23.07.2015
(51) Int. Cl.: H05K 1/18

(54) **A LIGHT EMITTING MODULE**
LICHTEMITTIERENDES MODUL
MODULE ÉLECTROLUMINESCENT

(30) Priority: 24.07.2014 EP 14178254
(43) Date of publication of application: 31.05.2017
(73) Proprietor: Philips Lighting Holding B.V., 5656 AE Eindhoven (NL)
(72) Inventor: VAN BOMMEL, Ties, NL-5656 AE Eindhoven (NL); HIKMET, Rifat Ata Mustafa, NL-5656 AE Eindhoven (NL); DIJKEN, Durandus Kornelius, NL-5656 AE Eindhoven (NL)
(74) Representative: Verweij, Petronella Daniëlle
(86) International application number: PCT/EP2015/066951
(87) International publication number: WO 2016/012574

(56) References cited:
- EP-A1- 2 447 747
- WO-A1-2009/149263
- WO-A1-2013/054693
- US-A- 5 838 247
- US-A1- 2005 002 190
- US-B1- 6 409 361

## Description

### FIELD OF THE INVENTION

The invention relates to a light emitting module. The invention also relates to a lamp and a luminaire comprising such a light emitting module. A method for changing the light intensity of a light emitting module is further provided.

### BACKGROUND OF THE INVENTION

Light emitting diodes (LEDs) are commonly, for practical as well as aesthetical reasons, used in luminaires for providing efficient general lighting and functional light in public spaces, buildings, offices, homes etc. The light output of a LED light source is, however, not generally sufficient for most applications, and several LED light sources have to be combined to generate sufficient light levels.

It is often desirable to change the shape or size of the luminaire as well as its light intensity in order to meet the needs of the lighting situation at hand.

This may, however, be difficult to achieve as a change in the shape of the luminaire may need rescaling and/or cutting of surfaces where the LEDs are mounted. In the case of lighting designs using wave guides, reshaping of the waveguides may correspondingly be needed.

Tailoring the light intensity by changing the number of LEDs in the luminaire is also not straight forward. LED luminaires are not easily scalable in size nor is the number of LED light sources used in the luminaire easy to adjust without having to change the design of the luminaire. Hence, the design of the LED luminaire has to be changed when more or fewer LEDs are required. A prior art solution is known from document US 2005/002190 A1. It is therefore desirable to have a LED luminaire which can easily be configured to have a desired shape and/or light intensity. It is further desirable if the LED luminaire is reshapable and resizable such that the same type of LED luminaire may be used in different lighting applications in which the size, shape and light intensity differ.

### SUMMARY OF THE INVENTION

It is an object of the present invention to overcome this problem, and to provide a light emitting module which is reshapable and which allows for the light intensity to be changed. It is further an object to provide a LED luminaire with efficient light distribution and to avoid high brightness spots appearing in the LED luminaire.

According to the invention, this and other objects are achieved by providing a light emitting module. The light emitting module comprises a flexible and/or foldable LED-carrier or strip comprising at least one light emitting diode having a light emitting surface, the LED-carrier forming a light cavity, and a light exit opening with an axis normal thereto and allowing light to exit the light cavity during operation of the light emitting module, wherein the light emitting surface of the at least one light emitting diode, faces the light cavity, and wherein a shape of the light exit opening is dependent on a flexing and/or folding of the LED-carrier. The top plate comprises a first electrically conductive layer and the bottom plate comprises a second electrically conductive layer, wherein the first electrically conductive layer and the second electrically conductive layer are, respectively, arranged to be in electrical contact with the first and the second electrically conductive portions of the LED-strip. By this arrangement efficient electrical contacting of the LED-strip may be achieved via the top and bottom plates of the light emitting module. In other words, the LEDs of the LED-strip may be efficiently powered through the electrical contacts formed between the LED-strip and the top and base plates. This simple and flexible way of electrical contacting enables a free positioning of the LED-strip over the electrical conductive layers of the top plate and the bottom plate, without the need for flexible, loose wiring to maintain electrical contact. Furthemore, the flexibility of the LED-strip is advantageous as a flexing and/or folding of the LED-strip changes the area of the light exit opening of the light emitting module such that the light intensity of the light exiting the light emitting module is changed. In other words, the power of the light emitted from the LEDs may be kept constant, while the intensity of the light emitting module is changed through a change in the area of the light exit opening. A light emitting module having a variable light intensity is thereby provided, i.e. the LED-strip may be shaped or reshaped such that the same light emitting module may, depending on requirements of the lighting application at hand, deliver different light intensities without the need of cutting of any surfaces where the LEDs are mounted. Hence, a change in the number of LEDs emitting light is not needed for changing the light intensity of the light emitting module. This is advantageous as it simplifies the design and manufacturing of the light emitting module. The same type of LED-strip may, for example, be used in several different lighting applications requiring different light intensities. Moreover, the same type of driver electronics may be used for all lighting module as all LED-strips of a given type comprises the same number of LEDs.

The *wording flexible* LED-carrier is here to be understood as a LED-carrier, for example a strip, ribbon or ring, being bendable such that a force that acts on the LED-strip may change the shape of the LED-strip. The LED-strip is pliable such that it may be bent without breaking. The LED-strip may be continuously flexible such that the LED-strip may be bent at any point along the strip. The LED-strip may be flexed repeatedly such that the same LED-strip may acquire different shapes. Alternatively, the LED-strip may comprise sections which are flexible. Where the expression "strip" is used in this application it is meant to be interpreted as broadly as the expression "carrier".

The *wording foldable LED-strip* should be construed as the LED-strip being jointed such that the LED-strip may be bent at discrete points along its length. The LED-strip may comprise hinges. By folding the LED-strip at a joint the shape of the LED-strip may be changed. The LED-strip may comprise a section in the vicinity of a joint or in between two joints that are inflexible.

The *LED-strip* is to be understood as a line or elongated section comprising at least one light emitting diode, LED. The LED-strip may comprise a plurality of LEDs arranged along a line or in an array. The LEDs may be arranged on one or several sides of the LED-strip.

By *light cavity* is meant an open or closed volume in which light from the LED is redistributed by means of diffuse reflection i.e. scattering or specular reflection. Light is thereby redirected by reflection, forward, backward scattering, refraction, and/or diffraction. The light cavity is further arranged to mix light from LEDs and may also be referred to as a light mixing cavity or a light mixing chamber. The mixing is achieved by e.g. scattering by multiple reflections of light within the light cavity. The light cavity provides light exiting the light cavity which has a more uniform intensity distribution in space. Hence, a light emitting module providing an increased uniform illumination is achieved.

The *light exit opening* is to be understood as a section or area through which light exits the light emitting module. In other words, light scattered or mixed in the light cavity escapes the light cavity through the light exit opening.

The light cavity may comprise an additional (second) cavity surface, wherein the additional cavity surface surrounds the LED-strip. The additional cavity surface allows for more flexibility when designing the light cavity. As the additional cavity surface surrounds the LED-strip a light cavity may for example be formed exterior to the LED-strip. Hence the volume of the light cavity may be increased. The additional cavity preferably is illuminated by an additional (second) LED-strip, but alternatively, might be illuminated via openings in the LED-strip of the (first) light cavity, said openings may then be opened or closed via a mutual rotation of a flexible, perforated strip adjacent to said (first) LED-strip to tune the illumination of the additional (second) cavity. The light cavity may comprise a plurality of cavities or chambers which improved tunability of the light intensity.

The LED-strip may comprise a flexible and/or foldable printed circuit board, PCB, substrate. This is advantageous as the PCB provides efficient electrical contacting of the LEDs and allows for electrical contacting of a driver electronics arranged to power the LEDs. The flexible PCB further provides efficient thermal management of the LEDs by comprising a thermally conducting material. The manufacturing of the light emitting module is further simplified as the LEDs may be pre-mounted on the PCB substrate.

The LED-strip may form a closed or an open loop. A larger range of shapes may be obtained by providing a LED-strip that forms a closed or open extension. As a result the tuning of the shape of the light exit opening is simplified, i.e. the area of the light emitting module through which light is emitted is easier to change. Light may additionally exit the light emitting module through the open part of the open loop. By adjusting the size of the opening of the open loop the intensity of the light emitted from the light emitting module may be changed. A more versatile light emitting module is thereby provided.

The light exit opening may further comprise an optical element such as a light diffuser element, a light diffractive element, or a light refractive element. This is advantageous as more light may be coupled out from the light emitting module. A more uniform light distribution may also be achieved. The cone of light emitted from the light emitting module may further be increased.

The wording *light diffuser element* should be construed as an optical element which is arranged to, by scattering, provide spreading and homogenization of non-uniform light.

The wording *light diffractive element* should be construed as an optical element which is arranged to, by diffraction, provide spreading and homogenization of non-uniform light.

The wording *light refractive element* should be construed as an optical element which is arranged to, by refraction, provide spreading and homogenization of non-uniform light.

The LED-strip may comprise a first electrically conductive portion and a second electrically conductive portion for applying a driving current to the at least one light emitting diode. The conductive portions provide simple and reliable electrical contacting of the LED-strip.

The light emitting module may further comprise a top plate and a bottom plate, wherein the LED-strip of the light emitting module is arranged in between the top plate and the bottom plate.

The two plates are arranged to, together with the LED-strip, form the light cavity of the light emitting module. A more well-defined light cavity may thereby be provided. The top plate and the bottom plate may further provide improved light mixing in the light cavity of the light emitting module. The plates may further protect the LED-strip from the environment outside the light emitting module.

The wording *plate* is to be construed as an object being less extended in one direction and more extended in the two other directions. In other words, the plate is elongated in only two directions. The plate may comprise one material or a plurality of materials and be substantially flat or comprise one or more curved portions.

The light exit opening may be arranged in the top plate and/or the bottom plate. Such an arrangement provides a well-defined positioning of the light exit surface relative to the LED-strip. This simplifies the manufacturing of the light emitting module.

The light exit opening of the top plate and/or the bottom plate may comprise the optical element. This provides improved out-coupling of light from the light emitting module. An improved light intensity from the light emitting module may thereby be obtained. A more homogeneous light distribution from the light emitting module may further be provided. The light emitted from the light emitting module may further have a larger cone of angles.

The top plate and/or the bottom plate may comprise a light reflective element. The light reflective element efficiently reflects light such that an increased light intensity of the light emitted from the light emitting module may be obtained.

The light emitting module may further comprise driver electronics for driving the at least one light emitting diode. This allows for a compact light emitting module.

According to an aspect of the present invention a LED-luminaire comprising the light emitting module described above is provided. A LED-luminaire having changeable light intensity is thereby provided. Hence, the same type of LED-luminaire may be used in different lighting applications. Moreover, the shape of the light emitting area of the LED-luminaire may be varied such that the visual appearance of the LED-luminaire may be changed. Hence, a more versatile LED-luminaire is provided.

According to another aspect a LED-lamp comprising the light emitting module described above is provided. The LED-lamp comprises and a lamp base which may be fitted or retrofitted in a lamp socket of known type. The lamp base may e.g. be threaded.

According to a forth aspect a method for changing the light intensity of a light emitting module is provided. The method comprising providing a light emitting module comprising, a flexible and/or foldable LED-strip comprising at least one light emitting diode, the LED-strip forming a light cavity, and a light exit opening allowing light to exit the light cavity, wherein the at least one light emitting diode faces the light cavity, and flexing and/or folding of the LED-strip such that the shape of the light exit opening is changed whereby the light intensity of a light emitting module is changed.

The function and benefits of using the lamp comprising the light emitting module and a method for changing the light intensity of a light emitting module are described above in relation to the light emitting module and the luminaire comprising the light emitting module. The above mentioned features, when applicable, apply to the third and forth aspect as well. In order to avoid undue repetition, reference is made to the above.

It is noted that the invention relates to all possible combinations of features recited in the claims.

### BRIEF DESCRIPTION OF THE DRAWINGS

This and other aspects of the present invention will now be described in more detail, with reference to the appended drawings showing embodiment(s) of the invention.
Fig. 1 is a schematic perspective view of a light emitting module according to an embodiment of the present invention.
Fig. 2a and b are schematic cross-sectional views of the same light emitting module as in FIG. 1 and correspond to two different light intensity of the light emitting module.
Fig. 3 is a schematic cross-sectional view of a light emitting module according to an embodiment of the present invention.
Fig. 4a and b are schematic cross-sectional views of a light emitting module according to an embodiment of the present invention.
Fig. 5 is a schematic perspective view of a light emitting module according to an embodiment of the present invention.
Fig. 6 is a cross-sectional side view of a light emitting module according to an embodiment of the present invention.
Fig. 7 illustrates how a resilient flexible LED-strip is arranged in between and electrically contacted to two electrically conductive layers.
Fig. 8 is a schematic cross-sectional view of a light emitting module according to an embodiment of the present invention.
Fig. 9 is a schematic cross-sectional view of a light emitting module according to an embodiment of the present invention.
Fig. 10 is a bottom view of a LED-luminaire comprising a light emitting module according to an embodiment of the present invention.
Fig. 11 is a schematic view of a LED-lamp comprising a light emitting module according to an embodiment of the present invention.
Fig. 12 is a flow diagram of a method for changing the light intensity of a light emitting module according to the present invention.

As illustrated in the figures, the sizes of layers and regions are exaggerated for illustrative purposes and, thus, are provided to illustrate the general structures of embodiments of the present invention. Like reference numerals refer to like elements throughout.

### DETAILED DESCRIPTION

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and fully convey the scope of the invention to the skilled person.

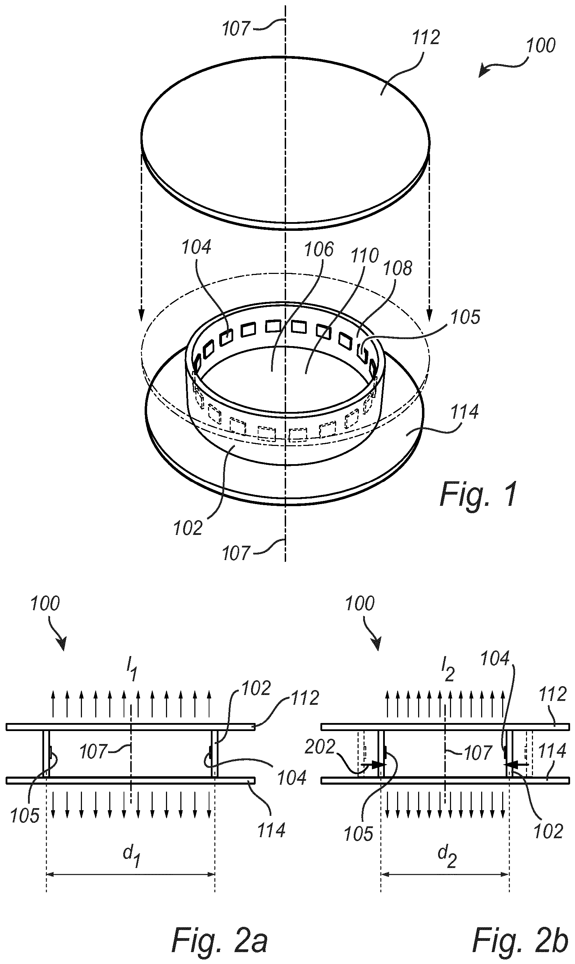

Figure 1 illustrates an embodiment of a light emitting module 100 according to the present invention. The light emitting module 100 comprises a closed loop around an axis 107 of a flexible LED-carrier 102, for example a strip, with a plurality of light emitting diodes, LEDs, 104 and a light exit opening 106 with the axis 107 normal to said light exit opening. The LEDs 104 are arranged on an inner surface 108 of the flexible LED-strip 102.

The flexible LED-carrier 102 is made of a flexible printed circuit board, PCB onto which the LEDs 104 are arranged. The PCB provides electrical contacting of the LEDs 104 and allows for electrical contacting of a driver electronics (not shown) arranged to power the LEDs 104. The flexible PCB further provides efficient thermal management of the LEDs 104 by comprising a thermally conducting material.

The flexible LED-strip 102 forms a light cavity 110 comprising light emitted from the LEDs 104. In other words, the LED-strip 102 defines at least a portion of the volume of the light cavity 110 and light emitted from the LEDs is efficiently coupled into the light cavity 110 as the LEDs 104 have respective light emitting surfaces 105 which are facing the light cavity 110.

The light cavity 110 is arranged to mix light from the LEDs 104 and may hence also be referred to as a light mixing cavity or a light mixing chamber. The mixing is achieved by multiple reflections of light within the light cavity 110. As a result, the light which exits the light cavity 110 has a more uniform intensity distribution in space. Hence, a light emitting module 100 with an increased uniform illumination is provided.

By flexing and/or folding of the LED-strip 102 the shape of the light exit opening 106 is changed although the perimeter of the LED-strip stays the same. The changed shape of the light exit opening 106 may translate to a change in the area of light exit opening. As the light intensity of the light emitting module 100 is defined by the light power emitted per unit area, a change in the area further translates to a change in light intensity for a given amount of light power emitted by the LEDs. A light emitting module 100 having a variable light intensity is thereby provided. This is advantageous as the same light emitting module 100 may, depending on requirements of the lighting application at hand, deliver different light intensities without the need of cutting of any surfaces where the LEDs 104 are mounted. A change in the number of LEDs 104 emitting light is also not needed for changing the light intensity of the light emitting module 100. The latter is advantageous as the same driver electronics may be used for several light emitting modules providing different light intensities.

The light emitting module 100 may further be reversely changed in light intensity, by shaping and reshaping of the shape of the light exit opening. In other words, the LED-strip may be reshapable such that the LED-strip 104 may be repeatedly flexed and/or folded.

It should be noted that a plurality of shapes may provide the same light intensity. The light module may, however, for such situations provide light emitting areas having different shape and/or orientation in space. The visual appearance of the light emitted from the light emitting module may thereby be changed. Hence, patterns comprising illuminated areas may be obtained.

As illustrated in figure 1, the light emitting module further comprises a top plate 112 and a bottom plate 114, where the LED-strip 102 is arranged in between the plates 112, 114. The two plates 112 and 114, together with the LED-strip 102, form the light cavity 110. The top plate 112 and the bottom plate 114 provides improved light mixing in the light cavity 110 of the light emitting module 100 as light may be reflected in the inner surfaces of the plates 112, 114. The plates 112, 114 furthers protect the LED-strip 102 from the environment outside the light emitting module 100. A more durable light emitting module 100 is thereby provided.

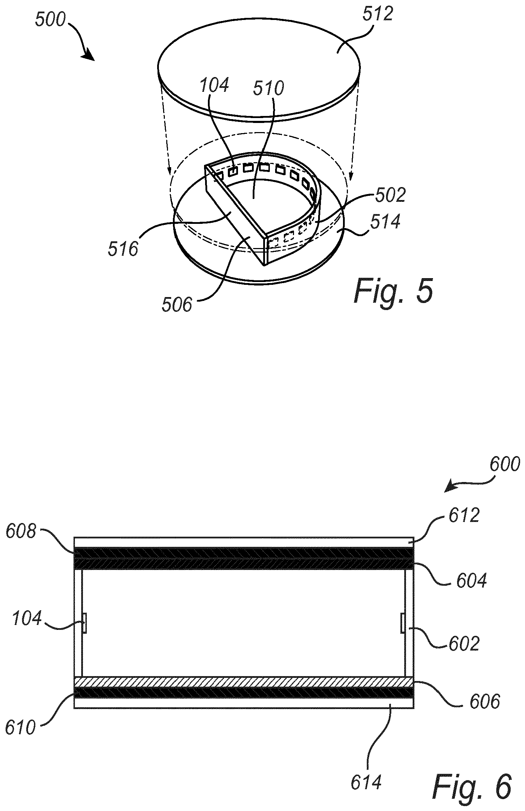

The top plate 112 and the bottom plate 114 are here made of translucent plastics, but may in other embodiments comprise materials such as glass, wood, and fabric, paper, cardboard and are each provided with an electrically conductive layer, which will be explained in more detail at the hand of Figure 6.

According to other embodiments the top and/ or the bottom plate comprise portions being perforated with one or more openings such that light may pass through the openings.

The light exit opening 106 is in this embodiment defined by the area of the close looped LED-strip 102. The translucent plastic of the top plate 112 and the bottom plate 114 further acts as a light diffuser element. In other words, light from the light cavity 110 is coupled out from light via the diffusing element such that a more uniform light distribution from the light emitting module is achieved. The cone of light emitted from the light emitting module is further increased by the light diffusion of the plates.

The wording *translucent* is to be understood as permitting the passage of light. The translucent plate may therefore comprise a portion that is clear, in other words transparent to light, and/or a portion that is transmitting and diffusing light such that the LEDs within the light emitting module cannot be seen clearly from outside the translucent plate. Expressed differently, *translucent* is to be understood as "permitting the passage of light" and a translucent material may either be clear (transparent) or transmitting and diffusing light so that objects beyond cannot be seen clearly. *Transparent* is to be understood as "able to be seen through".

According to other embodiments the top plate and/or the bottom plate may comprise a transparent material.

The light diffuser element may comprise a prismatic structure arranged to diffuse light. This allows for efficient redistribution of light emitted from the light emitting module, leading to a modified beam shape, e.g. 45 degrees angle full-width-half-max (FWHM).

According to one embodiment the top plate and/or the bottom plate comprises an electrically controllable diffusive glass, also called "smart-glass" which allows the optical properties, i.e. the light diffusiveness, of a plate to be changed by varying a electrical potential of at least a portion of the plate. The plate may for instance change from being translucent to transparent or vice versa.

Figures 2a and 2b are schematic cross-sectional views of the same light emitting module as in figure 1 and correspond to two different situations where the light emitting module 100 provides two different light intensities I₁ and I₂. The light intensity h is larger than the light intensity I₁ in this example, although the power of the light emitted by light emitting surface 105 of the LEDs 104 is the same for the two situations. The intensity difference is achieved by flexing the LED-strip such that the area of the light exit opening 106 around the optical axis 107 is changed. This flexing of the LED-strip 102 corresponds, in the cross-sections of figures 2a and 2b, to a change of the distances d₁ to d₂ between two points on the LED-strip 102, d₂ being smaller than d₁.

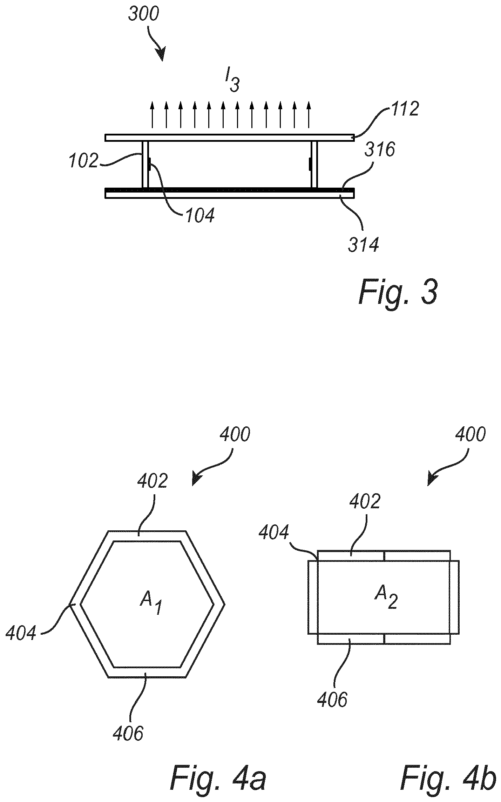

Figure 3 illustrates a light emitting module 300 similar to the embodiments described in previous figures, but instead of comprising a translucent bottom plate 114, the bottom plate 314 comprises a light reflective element 316. The intensity of the light emitted from the light emitting module 300 through the top plate 112 is thereby increased. The angular distribution of light emitted from the light emitting module 300 is further reduced compared to a similar light emitting module comprising a translucent bottom plate without a reflective element 316.

According to one embodiment the bottom plate 114 is a reflector, i.e. a diffuse reflective element or a specular reflective element, i.e. a mirror.

Figures 4a and 4b illustrate a light emitting module 400 comprising a foldable LED-strip 402. The foldable LED-strip is jointed 404 such that the LED-strip 402 may be bent at discrete points along its length. The LED-strip further comprises sections 406 in between the joints which are inflexible. Nevertheless, the shape of the LED-strip 402 may be changed by folding the LED-strip 402 at the joints 404. This is illustrated in figures 4a and 4b where the LED-strip 402 is transformed from a hexagonal structure, figure 4a, to a rectangular structure, figure 4b. As a result of the folding the inner areas A₁ and A₂ of the hexagonal and the rectangular structures differ in size. The intensity of the light exiting the light emitting module is changed by the transformation in shape.

The LED-strip 404 is according to this embodiment reshapable such that the LED-strip 404 may be folded more than one time. This allows for changes in the light intensity of the light emitting module 400.

The LED-strip may according to other embodiments comprise hinges.

Figure 5 illustrates a light emitting module 500 comprising a LED-strip 502 forming an open loop, a top plate 512 and a bottom plate 114and an optical element 516. The size of the opening of the LED-strip 502 sets the size of the light exit opening 506 of the light emitting module 500. A smaller size provides higher light intensity of the light emitted from the light emitting module 500. Hence, by folding and/or flexing the LED-strip 502 the light intensity of the light emitting module may be changed.

The top plate 512 and the bottom plate 514 both comprise a reflective surface (not shown) facing the light cavity 510. This increases the light intensity of the light emitted from the light emitting module 500.

The optical element 516 is in this embodiment described as a light diffuser element arranged at the light exit opening 506 of the light emitting module 500 such that light from the light cavity 510 is emitted via the light exit opening 506 through the light diffuser element. In other words, light from the LEDs 104, which may be scattered and/or reflected inside the light cavity 510 is sent out through the light diffuser element. This allows for a light emitting module 500 which provides spreading and homogenization of non-uniform light such that a more uniform light distribution may also be achieved. The cone of light emitted from the light emitting module may further be increased by for example providing a light diffuser element having a surface structure which is corrugated or patterned.

The light diffuser element may be describe as a translucent optical element and may be of a group of types comprising ground glass diffusers, Teflon diffusers, holographic diffusers and opal glass diffusers. The light diffuser element may further comprise a material such as glass or plastic which is painted in order to provide a diffusive effect. The person skilled in the art realizes that other types of light diffuser elements may be used in order to provide a more uniform light distribution.

According to other embodiments the optical element 516 may be a light diffractive element arranged to, by diffraction, provide spreading and homogenization of non-uniform light.

According to other embodiments the optical element 516 may be a light refractive element arranged to, by refraction, provide spreading and homogenization of non-uniform light.

According to other embodiments a light emitting module comprising an LED-strip with an open loop may be provided without having an optical element. For such an arrangement light is emitted through the opening section of the LED-strip. This provides improved directionality of the light emitted from the light emitting module.

In figure 6, a cross-sectional side view of a light emitting module 600 is illustrated. Show in the figure is a LED-strip 602 comprising a first electrically conductive portion 604 and a second electrically conductive portion 606. The first 604 and the second 606 electrically conductive portions are arranged to provide the light emitting diodes 104 of the LED-strip 602 with a driving current. A top plate 612 and a bottom plate 614 of the light emitting module 600 further comprises an electrically conductive layer 608 and an electrically conductive layer 610, respectively. The electrically conductive layer 608 of the top plate 612 is arranged to be in electrical contact with the first electrically conductive portion 604 of the LED-strip 102. The electrically conductive layer 610 is arranged to be in electrical contact with the electrically conductive portion 606 of the LED-strip 602. The first 604 and the second 606 electrically conductive portions are electrically isolated from each other such that a voltage applied to the electrically conductive layers 608 and 610 produce a driving current to the light emitting diodes of the LED-strip 602. Hence, a simple and reliable electrical contacting of the LED-strip 602 is provided.

The electrically conductive layers 608 and 610 at least partly cover the area of the top plate 612 and the bottom plate 614, respectively. Correspondingly the first electrically conductive portion 604 and the second electrically conductive portion 606 covers at least a portion of the LED-strip 602 such that the conductive portions are facing the respective conductive layers of the plates 612 and 614.

The electrically conductive layers 608 and 610 are preferably larger in extension than the first 604 and the second 606 electrically conductive portions of the LED-strip 600. Hence, efficient powering of the light emitting diodes may be provided for different shapes of the LED-strip 602. Powering of the LED-strip 602 may be provided also while the shape of the LED-strip 602 is changed.

The change of shape of the LED-strip 602 may be performed by means of an electrically driven motor moving at least a portion of the LED-strip 602.

The light emitting module 602 may comprise driver electronics for driving the light emitting diodes of the LED-strip (not shown).

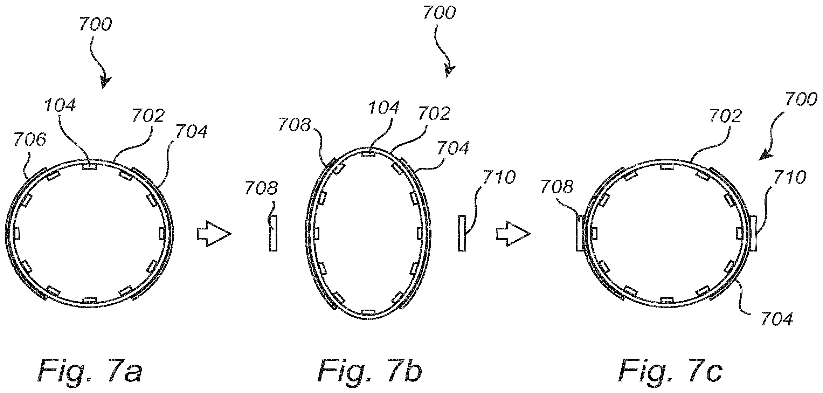

Figures 7a to 7b illustrates how a resilient flexible LED-strip 702 of a light emitting module 700 is arranged in between and electrically contacted to two electrically conductive layers 708 and 710. In the top view image of figure 7a, the LED-strip 702, having a cylindrical shape, appears as a circle. The flexible LED-strip 702 comprises a first electrically conductive portion 704 and a second electrically conductive portion 706. The electrically conductive portions 704 and 706 are arranged on the outer envelope surface of the LED-strip 702. Figure 7b illustrates the same LED-strip 702 being arranged in between the two electrically conductive layers 708 and 710. A force is here applied to the LED-strip 702 such that the cross-sectional surface takes a non-circular shape and the extension along a direction between the two electrically conductive layers is reduced. This simplifies the positioning of the LED-strip 702 in between the two electrically conductive layers 708 and 710.

Figure 7c shows the LED-strip 702 when the force is no longer applied. The resilient LED-strip 702 has at least partly regained it circular shape and the first electrically conductive portion 704 and a second electrically conductive portion 706 are in physical contact with the electrically conductive portions 704 and 706, respectively. Hence, the electrical contacts needed for driving the light emitting diodes 104 of the light emitting module 700 is provided.

A greater force may be applied to the LED-strip 702 by reducing the distance between the two electrically conductive layers 708 and 710, i.e. the distance being smaller than the extension of the LED-strip along the direction between the conductive layers 708. This is advantageous as the LED-strip 702 may be better held in place by the force and problems associated with a short cut may be mitigated.

The term electrically conductive layer should here be understood in its broadest sense. The layer may for example take any form, for example a disk or contact pin, as long as a sufficiently large contact surface is provided between the layer and an electrically conductive portion of the LED-strip such that efficient powering of a light emitting diode of the LED-strip is provided.

It should be noted that more than two electrically conductive layers may be used. This is advantageous as it provided more options to position a LED-strip. By, for example, changing the distance between the electrically conductive layers the shape of the LED-strip may be changed.

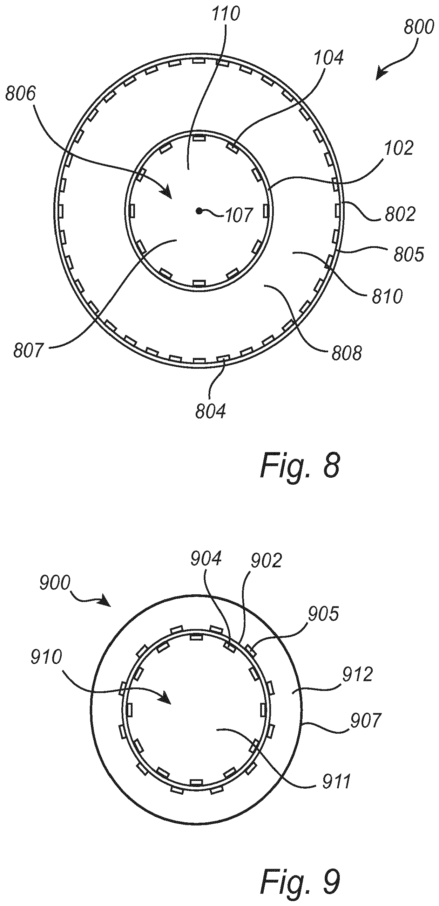

Figure 8 illustrates a light emitting module 800 comprising a LED-strip 102 which is surrounded by an additional LED-strip 802. The LED-strips 102 and 802 are concentrically arranged around an optical axis 107 and comprise a plurality of light emitting diodes 104 and 804, respectively. An inner envelope surface of the additional LED-strip 802 forms an additional cavity surface 805 which surrounds the LED-strip 102. The additional cavity surface 805 surrounds the LED-strip 102 such that an additional light cavity 810 is formed exterior to the LED-strip 102. This is advantageous as the total volume of the light cavity of light emitting module 800 is increased. The light emitting module 800 further comprises two light cavities 110 and 810 which may be changed in shape and size by changing the shape of the LED-strips 102 or 802. Correspondingly, the area of the light exiting opening 806 of a light emitting module 800 comprises a first portion 807 and a second portion 808. Changes in the shape of LED-strips 102 and 802 alter the area of the light exit opening 806. More specifically, a folding and/or flexing of the LED-strips 102 and 802 allows for tuning of the area of the first 807 and the second 808 portions of the light exit opening 806. Hence, the light intensity of the light exiting the light cavities 110 and 810 may be changed which offers an improved tunability of the light intensity of the light emitting module.

The light emitting diodes 104 of the LED-strip 104 may emit light with a different spectral composition than the light emitting diodes 804 of the additional LED-strip 802. Hence, it is possible to tune the overall spectral composition of the light emitted by the light emitting module by flexing and/or folding of the two LED-strips 102 and 802.

According to an embodiment the first portion 807 and a second portion 808 of the light exiting opening 806 may emit light trough a top plate and bottom plate (not shown) comprising light guiding optics. The light guiding optics may be arranged such that light emitted from the first portion 807 has a Lambertian light output whereas the light emitted from the second portion 808 is emitted at an angle, for example 45 degrees.

According to another embodiment the light emitting module comprises more than two LED-strips.

Figure 9 illustrates an alternative embodiment of a light emitting module 900. According to this embodiment a LED-strip 900 is provided which comprise a plurality of light emitting diodes 904 and 905 arranged on an inner and an outer surface of the LED-strip 902 respectively. A light cavity 910 comprises a first light cavity 911 formed inside the LED-strip 902 and a second light cavity 912 formed outside the LED-strip 902. The light cavity 910 comprises an additional cavity surface 907. This arrangement is advantageous as only one LED-strip is needed to form a light emitting module 900 having a plurality of light cavities 911, and 912. Similarly, to the discussion related to the embodiment of figure 8, a flexing and/or folding of the LED-strip 902 offers the tunability of the volume of the light cavities 911 and 912. Hence, this embodiment also provides a light emitting module 900 where the light intensity may be tuned. Moreover, the spectral composition of the light exiting the light emitting module may be changed by using light emitting diodes 904 and 905 that have different spectral compositions on the outside and the inside of the LED-strip 902.

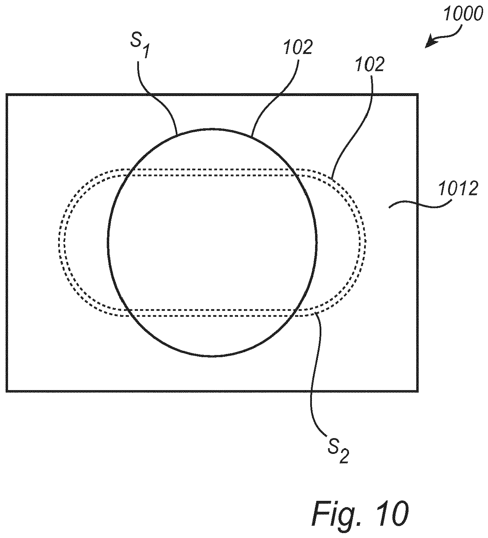

Figure 10 illustrates a bottom view of a LED-luminaire comprising a light emitting module as described above and a translucent cover 1012. The LED-luminaire 1000 offers a variable light intensity, which is achieved by changing the flexing/and or folding of a LED-strip 102. The from the flexing and/or folding resulting shapes S₁ and S₂ shown in figure 10 exemplify how the LED-strip 102 can take different forms while the perimeter of the LED-strip 102 is kept constant. The surface area covered by the LED-strip 102 may accordingly be changed, i.e., S₁ has a different surface area that S₂, which allows for adjustment of the intensity of the light, emitted from the LED-luminaire 1000. Moreover, the shape of the light emitting area of the LED-luminaire is varied such that the visual appearance of the light emitting of the may be changed. Hence, the same type of LED-luminaire may be used in different lighting applications and further provide decorative effects. A more versatile LED-luminaire 1000 is thereby provided.

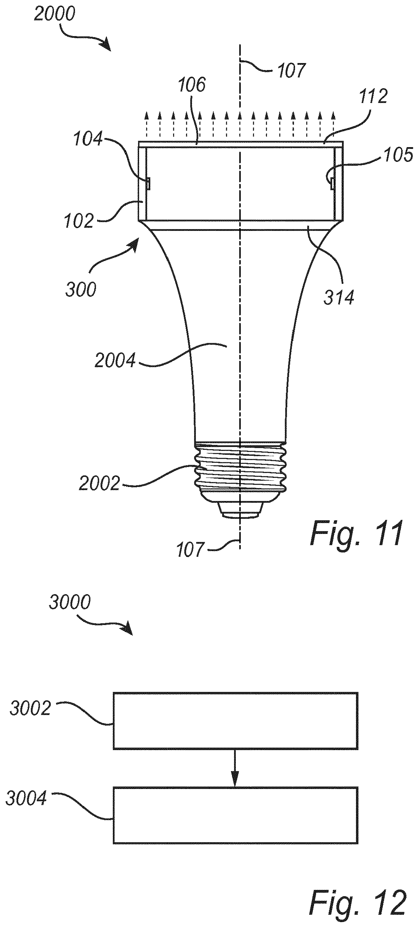

A LED-lamp comprising the light emitting module described above is illustrated in figure 11. The LED-lamp 2000 comprises a lamp base 2002 which may be mounted into a socket (i.e. an Edison screw fitting) and a housing 2004 arranged to house the light emitting module 300. The light emitting module 300 is in this embodiment the same module as describe above in relation to figure 3. Hence, the lighting emitting module 102 comprises a LED-strip 102 with LEDs 104 having respective light emitting surfaces 105 facing the light exit opening 106, a top plate 112 being provided in the light exit opening, which extends together with an opposed bottom plate 314 transverse to the optical axis 107. The bottom plate 314 comprises a light reflective element (not shown) to increase the light emitted through the top plate 112. The light emitting module 300 is arranged in the housing 2004, which further include electrical circuitry for driving the at least one light emitting diode of the LED-strip 102. The lamp base 2002 further comprises a threaded conducting portion arranged to be screwed into a socket such that power may be delivered to the LED-strip 102. The light intensity of the LED-lamp 2000 is changeable by flexing and/or folding of the LED-strip 102.

Figure 12 shows a flow diagram of a method for changing the light intensity of a light emitting module, the method comprising: providing 3002 a light emitting module comprising: a flexible and/or foldable LED-strip comprising at least one light emitting diode, the LED-strip forming a light cavity, and a light exit opening allowing light to exit the light cavity, wherein the at least one light emitting diode faces the light cavity, and flexing and/or folding 3004 of the LED-strip such that the shape of the light exit opening is changed whereby the light intensity of a light emitting module is changed.

The function and benefits of the method for changing the light intensity of a light emitting module are described above in relation to the light emitting module.

The person skilled in the art realizes that the present invention by no means is limited to the preferred embodiments described above. On the contrary, many modifications and variations are possible within the scope of the appended claims.

For example, according to an embodiment, the additional cavity surface may have a shape comprising a curved portion having a curvature which is smaller than what may be achieved by flexing/and or folding the LED-strip. Hence a light emitting module having a wider range of shapes may be provided.

A light emitting module may according to other embodiments comprise an intermediate layer (not shown) which may be arranged in between a top plate and a bottom plate. The intermediate layer may comprise at least one opening of a given shape in which a LED-strip may be arranged. The shape of the opening, i.e. its periphery, may be used as a template for forming and/or flexing the LED strip. The intermediate layer may in other embodiments comprise a slit or grow in which a LED-strip may be at least partly located such that the shape of the LED-strip is determined by the shape of the slit or groove. This simplifies the forming and/or flexing of the LED-strip to a predetermined shape and may help maintain the shape of the flexed and/or folded LED-strip.

The intermediate layer may comprise a translucent material and/or transparent material. The intermediate layer may comprise ethylene vinyl acetate, EVA, or polymethylmetacrylat, PMMA.

The surface of the intermediate layer may form an additional cavity surface.

The LED-lamp 2000 may comprise an envelope or a bulb.

It should be noted that in the above description strips comprising a light emitting diode (LED) has been described and hence the wording LED-strip. The skilled person in the art, however, realizes that the strip may comprise other solid state light sources such as a laser diode. To this end, the strip may comprise an organic light emitting diode (OLED). The strip may additional comprise a plurality of different light sources such as a laser diode and a LED.

Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. A light emitting module (100, 500, 600) comprising,
a flexible and/or foldable LED-carrier or strip (102, 402, 502, 602, 702, 802, 902) comprising at least one light emitting diode (104, 904, 905) having a light emitting surface (105), the LED-carrier (102, 402, 502, 602, 702, 802, 902) forms a light cavity (110, 510, 810, 910) and is arranged in between a top plate (112, 512, 612) and a bottom plate (114, 514, 614), and
a light exit opening (106, 506, 806) with an axis (107) normal thereto and allowing light to exit the light cavity (110, 510, 810, 910) during operation of the light emitting module,
wherein the light emitting surface (105) of the at least one light emitting diode (104, 904, 905), faces the light cavity (110, 510, 810, 910),
wherein a shape of the light exit opening (106, 506, 806) is dependent on a flexing and/or folding of the LED-carrier (102, 402, 502, 602, 702, 802, 902), **characterized in that** the top plate (612) comprises a first electrically conductive layer (608) and the bottom plate comprises (614) a second electrically conductive layer (610), wherein the first electrically conductive layer (608) and the second electrically conductive layer (610) are, respectively, arranged to be in electrical contact with a first (604) and a second (606) electrically conductive portions of the LED-strip (602).

2. The light emitting module according to claim 1, wherein the light cavity (806, 910) comprises an additional cavity surface (805, 907), wherein the additional cavity surface (805, 907) surrounds the LED-strip (102, 902).

3. The light emitting module according to any of the claim 1 or 2, wherein the LED-strip (102, 402, 502, 602, 702, 802, 902) comprises a flexible and/or foldable printed circuit board, PCB, substrate.

4. The light emitting module according to any of the claims 1 to 3, wherein the LED-strip (102, 402, 502, 602, 702, 802, 902) forms a closed or an open loop.

5. The light emitting module according to any of the claims 1 to 4, wherein the light exit opening is arranged in the top plate (112) and/or the bottom plate (114).

6. The light emitting module according to any of the claims 1 to 5, wherein the light exit opening (106, 506, 806) further comprising an optical element (516).

7. The light emitting module according to claim 6, wherein the light exit opening of the top plate and/or the bottom plate comprises the optical element.

8. The light emitting module according to any of the claims 1 to 7, wherein the top plate and/or the bottom plate (314) comprises a light reflective element (316).

9. The light emitting module according to any of the claims 1 to 8 further comprising driver electronics for driving the at least one light emitting diode.

10. A LED-luminaire (1000) comprising the light emitting module (100, 300, 400, 500, 600, 700, 800, 900) according to any of the claims 1 to 9.

11. A LED-lamp (2000) comprising the light emitting module (100, 300, 400, 500, 600, 700, 800, 900) according to any of the claims 1 to 9, and a lamp base.

12. A method for changing the light intensity of a light emitting module, the method (3000) comprising;
providing (3002) a light emitting module comprising,
a flexible and/or foldable LED-carrier or strip arranged in between a top plate (112, 512, 612) and a bottom plate (114, 514, 614) and comprising at least one light emitting diode having a light emitting surface, the LED-carrier forming a light cavity, and
a light exit opening with an axis normal thereto and allowing light to exit the light cavity during operation of the light emitting module,
wherein the light emitting surface of the at least one light emitting diode faces the light cavity, and
flexing and/or folding (3004) of the LED-carrier such that the shape of the light exit opening is changed whereby the light intensity of a light emitting module is changed and establishing electrical contact between a first (604) and a second (606) electrically conductive portions of the LED-strip (602) with a first electrically conductive layer (608) comprised in the top plate (612) and with a second electrically conductive layer (610) comprised in the bottom plate (614).

## Patentansprüche

1. Lichtemittierendes Modul (100, 500, 600), umfassend,
einen biegsamen und/ oder faltbaren LED-Träger oder Streifen (102, 402, 502, 602, 702, 802, 902), zumindest eine lichtemittierende Diode (104, 904, 905) umfassend, die eine lichtemittierende Oberfläche (105) aufweist, wobei der LED-Träger (102, 402, 502, 602, 702, 802, 902) einen Lichthohlraum (110, 510, 810, 910) bildet und zwischen einer Deckplatte (112, 512, 612) und einer Bodenplatte (114, 514, 614) angeordnet ist, und
eine Lichtausgangsöffnung (106, 506, 806) mit einer Achse (107), die normal dazu steht und es dem Licht ermöglicht, den Lichthohlraum (110, 510, 810, 910) während des Betriebs des lichtemittierenden Moduls zu verlassen,
wobei die lichtemittierende Oberfläche (105) von der zumindest einen lichtemittierenden Diode (104, 904, 905) dem Lichthohlraum (110, 510, 810, 910) zugewandt ist,
wobei eine Form der Lichtausgangsöffnung (106, 506, 806) von einer Biegung und/ oder Faltung des LED-Trägers (102, 402, 502, 602, 702, 802, 902) abhängig ist,
**dadurch gekennzeichnet, dass**
die Deckplatte (612) eine erste elektrisch leitende Schicht (608) umfasst und die Bodenplatte (614) eine zweite elektrisch leitende Schicht (610) umfasst, wobei die erste elektrisch leitende Schicht (608) und die zweite elektrisch leitende Schicht (610) jeweils angeordnet sind, um in elektrischem Kontakt mit einem ersten (604) und einem zweiten (606) elektrisch leitenden Abschnitt des LED-Streifens (602) zu stehen.

2. Lichtemittierendes Modul nach Anspruch 1, wobei der Lichthohlraum (806, 910) eine zusätzliche Hohlraumoberfläche (805, 907) umfasst, wobei die zusätzliche Hohlraumoberfläche (805, 907) den LED-Streifen (102, 902) umgibt.

3. Lichtemittierendes Modul nach einem der Ansprüche 1 oder 2, wobei der LED-Streifen (102, 402, 502, 602, 702, 802, 902) ein biegsames und/ oder faltbares bedrucktes Leiterplatten-, PCB-Substrat umfasst.

4. Lichtemittierendes Modul nach einem der Ansprüche 1 bis 3, wobei der LED-Streifen (102, 402, 502, 602, 702, 802, 902) einen geschlossenen oder offenen Kreislauf bildet.

5. Lichtemittierendes Modul nach einem der Ansprüche 1 bis 4, wobei die Lichtausgangsöffnung in der Deckplatte (112) und/ oder der Bodenplatte (114) angeordnet ist.

6. Lichtemittierendes Modul nach einem der Ansprüche 1 bis 5, wobei die Lichtausgangsöffnung (106, 506, 806) weiter ein optisches Element (516) umfasst.

7. Lichtemittierendes Modul nach Anspruch 6, wobei die Lichtausgangsöffnung der Deckplatte und/ oder der Bodenplatte das optische Element umfasst.

8. Lichtemittierendes Modul nach einem der Ansprüche 1 bis 7, wobei die Deckplatte und/ oder die Bodenplatte (314) ein lichtreflektierendes Element (316) umfasst.

9. Lichtemittierendes Modul nach einem der Ansprüche 1 bis 8, weiter eine Treiberelektronik zum Ansteuern der zumindest einen lichtemittierenden Diode umfassend.

10. LED-Leuchte (1000), ein lichtemittierendes Modul (100, 300, 400, 500, 600, 700, 800, 900) nach einem der Ansprüche 1 bis 9 umfassend.

11. LED-Lampe (2000), ein lichtemittierendes Modul (100, 300, 400, 500, 600, 700, 800, 900) nach einem der Ansprüche 1 bis 9, und einen Lampensockel umfassend.

12. Verfahren zum Ändern der Lichtintensität eines lichtemittierenden Moduls, wobei das Verfahren (3000) umfasst;
Bereitstellen (3002) eines lichtemittierenden Moduls, umfassend,
einen biegsamen und/ oder faltbaren LED-Träger oder Streifen, der zwischen einer Deckplatte (112, 512, 612) und einer Bodenplatte (114, 514, 614) angeordnet ist, und zumindest eine lichtemittierende Diode umfasst, die eine lichtemittierende Oberfläche aufweist, wobei der LED-Träger einen Lichthohlraum bildet, und
eine Lichtausgangsöffnung mit einer Achse, die normal dazu steht und es dem Licht ermöglicht, den Lichthohlraum während des Betriebs des lichtemittierenden Moduls zu verlassen,
wobei die lichtemittierende Oberfläche von der zumindest einen lichtemittierenden Diode dem Lichthohlraum zugewandt ist, und
Biegen und/ oder Falten (3004) des LED-Trägers, sodass sich die Form der Lichtausgangsöffnung ändert, wodurch die Lichtintensität eines lichtemittierenden Moduls geändert wird, und Herstellen eines elektrischen Kontakts zwischen einem ersten (604) und einer zweiten (606) elektrisch leitenden Abschnitt des LED-Streifens (602) mit einer ersten elektrisch leitenden Schicht (608), die in der Deckplatte (612) enthalten ist und mit einer zweiten elektrisch leitenden Schicht (610), die in der Bodenplatte (614) enthalten ist.

## Revendications

1. Module électroluminescent (100, 500, 600) comprenant,
un support ou une bande à LED flexibles et/ou pliables (102, 402, 502, 602, 702, 802, 902) comprenant au moins une diode électroluminescente (104, 904, 905) ayant une surface électroluminescente (105), le support à LED (102, 402, 502, 602, 702, 802, 902) forme une cavité lumineuse (110, 510, 810, 910) et est agencé entre une plaque supérieure (112, 512, 612) et une plaque inférieure (114, 514, 614), et
une ouverture de sortie de lumière (106, 506, 806) avec un axe (107) normal par rapport à celle-ci et permettant à la lumière de sortir de la cavité lumineuse (110, 510, 810, 910) pendant le fonctionnement du module électroluminescent,
dans lequel la surface électroluminescente (105) de l'au moins une diode électroluminescente (104, 904, 905) fait face à la cavité lumineuse (110, 510, 810, 910),
dans lequel une forme de l'ouverture de sortie de lumière (106, 506, 806) dépend d'une flexion et/ou d'un pliage du support à LED (102, 402, 502, 602, 702, 802, 902),
**caractérisé en ce que**
la plaque supérieure (612) comprend une première couche électroconductrice (608) et la plaque inférieure (614) comprend une seconde couche électroconductrice (610), dans lequel la première couche électroconductrice (608) et la seconde couche électroconductrice (610) sont, respectivement, agencées pour être en contact électrique avec une première (604) et une seconde (606) partie électroconductrice de la bande à LED (602).

2. Module électroluminescent selon la revendication 1, dans lequel la cavité lumineuse (806, 910) comprend une surface de cavité supplémentaire (805, 907), dans lequel la surface de cavité supplémentaire (805, 907) entoure la bande à LED (102, 902).

3. Module électroluminescent selon l'une quelconque des revendications 1 ou 2, dans lequel la bande à LED (102, 402, 502, 602, 702, 802, 902) comprend un substrat de carte de circuit imprimé, PCB, flexible et/ou pliable.

4. Module électroluminescent selon l'une quelconque des revendications 1 à 3, dans lequel la bande à LED (102, 402, 502, 602, 702, 802, 902) forme une boucle fermée ou ouverte.

5. Module électroluminescent selon l'une quelconque des revendications 1 à 4, dans lequel l'ouverture de sortie de lumière est agencée dans la plaque supérieure (112) et/ou la plaque inférieure (114).

6. Module électroluminescent selon l'une quelconque des revendications 1 à 5, dans lequel l'ouverture de sortie de lumière (106, 506, 806) comprend en outre un élément optique (516).

7. Module électroluminescent selon la revendication 6, dans lequel l'ouverture de sortie de lumière de la plaque supérieure et/ou la plaque inférieure comprend l'élément optique.

8. Module électroluminescent selon l'une quelconque des revendications 1 à 7, dans lequel la plaque supérieure et/ou la plaque inférieure (314) comprennent un élément réfléchissant la lumière (316).

9. Module électroluminescent selon l'une quelconque des revendications 1 à 8 comprenant en outre de l'électronique de commande pour commander l'au moins une diode électroluminescente.

10. Luminaire à LED (1000) comprenant le module électroluminescent (100, 300, 400, 500, 600, 700, 800, 900) selon l'une quelconque des revendications 1 à 9.

11. Lampe à LED (2000) comprenant le module électroluminescent (100, 300, 400, 500, 600, 700, 800, 900) selon l'une quelconque des revendications 1 à 9, et un culot de lampe.

12. Procédé permettant de changer l'intensité lumineuse d'un module électroluminescent, le procédé (3000) comprenant :
la fourniture (3002) d'un module électroluminescent comprenant,
un support ou une bande à LED flexibles et/ou pliables agencés entre une plaque supérieure (112, 512, 612) et une plaque inférieure (114, 514, 614) et comprenant au moins une diode électroluminescente ayant une surface électroluminescente, le support à LED formant une cavité lumineuse, et
une ouverture de sortie de lumière avec un axe normal par rapport à celle-ci et permettant à la lumière de sortir de la cavité lumineuse pendant le fonctionnement du module électroluminescent,
dans lequel la surface électroluminescente de l'au moins une diode électroluminescente fait face à la cavité lumineuse, et
la flexion et/ou le pliage (3004) du support à LED de telle sorte que la forme de l'ouverture de sortie de lumière soit changée moyennant quoi l'intensité lumineuse d'un module électroluminescent est changée, et l'établissement d'un contact électrique entre une première (604) et une seconde (606) partie électroconductrice de la bande à LED (602) avec une première couche électroconductrice (608) comprise dans la plaque supérieure (612) et avec une seconde couche électroconductrice (610) comprise dans la plaque inférieure (614).
